# EUROPEAN PATENT APPLICATION

(11) **EP 4 672 607 A1**
(43) Date of publication of application: **31.12.2025**
(21) Application number: 24774042.6
(22) Date of filing: 15.03.2024
(51) Int. Cl.: H03K 17/10, H03K 17/082, H03K 17/56, H03K 17/687

(54) **RADIO FREQUENCY SWITCH CIRCUIT, APPARATUS AND TERMINAL**

(30) Priority: 17.03.2023 CN 202310296634
(71) Applicant: Huawei Technologies Co., Ltd., Shenzhen, Guangdong 518129 (CN)
(72) Inventor: YANG, Fan, Shenzhen, Guangdong 518129 (CN); XU, Jiaojiao, Shenzhen, Guangdong 518129 (CN); PENG, Bo, Shenzhen, Guangdong 518129 (CN)
(74) Representative: Thun, Clemens
(86) International application number: PCT/CN2024/082006
(87) International publication number: WO 2024/193477

(57) **Abstract**

This application provides a radio frequency switch circuit and apparatus, and a terminal, including at least one radio frequency signal channel. The radio frequency signa6l channel includes a signal input end, a signal output end, and a parallel branch. The parallel branch includes a plurality of switch devices and a plurality of first capacitors. First electrodes and second electrodes of the plurality of switch devices are sequentially connected. A first electrode of a 1^{st} switch device is connected to the signal input end or the signal output end. A second electrode of a last switch device is grounded. The switch devices are divided into a plurality of switch device groups. The switch device group includes at least one switch device. In each switch device group, a first electrode of a switch device that is close to the signal input end or the signal output end is connected, through the first capacitor, to a second electrode of a switch device that is at the signal input end or the signal output end. The first capacitors with different capacitance values are connected in parallel to two ends of the switch device, so that a voltage allocated to each switch device in the radio frequency switch circuit is less than a breakdown voltage of the switch device, thereby improving a power tolerance.

## Description

### CROSS-REFERENCE TO RELATED APPLICATIONS

This application claims priority to Chinese Patent Application No. 202310296634.5, filed with the China National Intellectual Property Administration on March 17, 2023 and entitled "RADIO FREQUENCY SWITCH CIRCUIT AND APPARATUS, AND TERMINAL", which is incorporated herein by reference in its entirety.

### TECHNICAL FIELD

This application relates to the field of antenna circuits, and in particular, to a radio frequency switch circuit and apparatus, and a terminal.

### BACKGROUND

A radio frequency switch is one of important parts of a radio frequency front end, and the radio frequency switch is a switch used to control time division duplex (time division duplex, TDD) switching in a wireless communication system. As modem wireless communication systems rapidly develop, systems such as mobile communication systems, radar systems, and satellite systems impose higher requirements on an insertion loss, isolation, a power capacity, a switching speed, and the like of a transceiver switch. To improve the isolation, a parallel branch usually needs to be designed on a single-pole double-throw (single-pole double-throw, SPDT) branch. When the branch is in a gated state, the parallel branch is in a closed state.

When a high-power signal is input, there is a high-voltage input to the parallel branch, and a voltage allocated to each switch device is less than a breakdown voltage of the switch device by stacking a quantity of switch devices. However, due to impact of a switch device-to-ground parasitic capacitance, voltages allocated to the switch devices are uneven, and a higher voltage is allocated to a switch device that is closer to a power signal input source. Therefore, a radio frequency switch circuit needs to be designed, so that even voltages are allocated to the switch devices, thereby improving a power tolerance.

### SUMMARY

This application provides a radio frequency switch circuit and apparatus, and a terminal. First capacitors with different capacitance values are connected in parallel to two ends of a switch device, so that a voltage allocated to each switch device on the radio frequency switch circuit is less than a breakdown voltage of the switch device, thereby improving a power tolerance.

According to a first aspect, this application provides a radio frequency switch circuit, including at least one radio frequency signal channel. Each radio frequency signal channel includes a signal input end configured to input a radio frequency signal, a signal output end configured to output a radio frequency signal, and a parallel branch disposed between the signal input end and the ground or between the signal output end and the ground. The parallel branch includes a plurality of switch devices and a plurality of first capacitors, first electrodes and second electrodes of the plurality of switch devices are sequentially connected, a first electrode of a 1^{st} switch device is connected to the signal input end or the signal output end, and a second electrode of a last switch device is grounded. The plurality of switch devices are divided into a plurality of switch device groups, each switch device group includes at least one switch device, and in each switch device group, a first electrode of a switch device that is close to the signal input end or the signal output end is connected, through the first capacitor, to a second electrode of the switch device that is at the signal input end or the signal output end.

Because a radio frequency voltage swing of the radio frequency signal is large, a sufficient quantity of switch devices need to be stacked on the parallel branch, so that an allocated voltage of each switch device does not exceed a breakdown voltage. In addition, after the circuit is packaged into a chip, a parasitic capacitor exists between the ground of a packaging substrate and the first electrode and the second electrode of each switch device. Because a voltage between a ground cable and the signal input end or the signal output end is distributed to each switch device in an entire loop, a part of the voltage is allocated to each switch device. If parasitic capacitances generated by the switch devices are approximately the same, the switch device that is closer to the signal input end or the signal output end bears a higher voltage. If an impedance of the switch device close to the radio frequency signal needs to be reduced, correspondingly, the first capacitor with a larger capacitance value needs to be connected in parallel to the switch device close to the radio frequency signal. The first capacitor is connected in parallel to an inherent parasitic capacitor in the switch device, so that a voltage allocated to each switch device in the radio frequency switch circuit is less than a breakdown voltage of the switch device. This improves uniformity of a voltage drop on each switch device, further improves a voltage withstand capability of the radio frequency switch circuit, and avoids a problem that the switch device in the radio frequency switch circuit is prone to damage when subject to inconsistent voltages.

To avoid damage to the radio frequency switch circuit caused by uneven voltage allocation of each switch device, in an implementation, each switch device group includes one switch device, and the source of the switch device is connected to the drain of the switch device through the first capacitor, so that a voltage allocated to each switch device is less than a breakdown voltage of the switch device, thus preventing damage to the radio frequency switch circuit.

In an implementation, each switch device group includes at least two switch devices, the parallel branch further includes a plurality of second capacitors, and a first electrode and a second electrode of a switch device that is close to the signal input end or the signal output end in each switch device group are connected through the second capacitor.

Because the switch device close to the radio frequency signal needs to be connected in parallel to a capacitor with a larger capacitance, the first electrode and the second electrode of the switch device that is close to the signal input end or the signal output end in each switch device group may be connected through the second capacitor. By using the foregoing structure, it is equivalent to that the switch device close to the radio frequency signal in each switch device group is connected in parallel to both the first capacitor and the second capacitor, and that another switch device in each switch device group is connected in parallel to the first capacitor. In this way, even if a capacitor with a large capacitance value needs to be connected in parallel, in the structure provided in this application, a capacitance value of each capacitor may be reduced by superimposing the first capacitor and the second capacitor, to reduce a circuit layout area.

In an implementation, each switch device group includes a first switch device and a second switch device. The first switch device is close to the signal input end or the signal output end, the second switch device is away from the signal input end or the signal output end, a first electrode of the first switch device is connected to a second electrode of the second switch device through the first capacitor, and the first electrode and a second electrode of the first switch device are connected to each other through the second capacitor.

In this structure, starting from the switch device close to the signal input end or the signal output end, every two switch devices are considered as a whole, and one first capacitor is first connected in parallel to the two switch devices, to implement voltage equalization between the switch device groups. When switch device-to-ground parasitic capacitances are the same, a largest capacitance value of the first capacitor may be reduced by one time, thereby greatly reducing a layout area. Then, the second capacitor is connected in parallel to the first switch device close to the signal input end or the signal output end in the switch device group, to equalize voltages of the first switch device and the second switch device in the switch device group. Finally, allocated voltages of all the switch devices are basically equal, and a maximum power tolerance of the radio frequency switch circuit is increased.

In an implementation, the switch device is an N-type MOS transistor or a P-type MOS transistor, and the radio frequency signal channel is configured to receive an external radio frequency signal or transmit a radio frequency signal to the outside.

In an implementation, the radio frequency switch circuit further includes: a first selection signal input end, a first selection signal output end, and a common signal input/output end, where the first selection signal input end is configured to send a radio frequency signal to the common signal input/output end; and the common signal input/output end is configured to send, to the outside, the radio frequency signal input from the first signal input end, and is further configured to receive an external radio frequency signal and transmit the received external radio frequency signal to the first selection signal output end. The radio frequency switch circuit specifically includes two radio frequency signal channels. One radio frequency signal channel is disposed between the common signal input/output end and the first selection signal input end, and the other radio frequency signal channel is disposed between the common signal input/output end and the first selection signal output end.

The radio frequency switch circuit is a single-pole double-throw radio frequency transceiver switch circuit. When the radio frequency switch circuit is configured to transmit a radio frequency signal to the outside, the radio frequency switch circuit is in a transmit mode. The radio frequency signal is generated by a transmitter, processed by an amplification circuit, flows in from the first selection signal input end, and is transmitted through the common signal input/output end. When the radio frequency switch circuit is configured to receive a radio frequency signal from the outside, the radio frequency switch circuit is in a receive mode. After being received from the common signal input/output end, the radio frequency signal flows into the first selection signal output end, to be transmitted to a receiver.

In an implementation, when the radio frequency switch circuit sends the radio frequency signal to the outside through the common signal input/output end, a switch device of the parallel branch of the radio frequency signal channel disposed between the common signal input/output end and the first selection signal input end is turned off. When the radio frequency switch circuit receives an external radio frequency signal form the common signal input/output end, a switch device of the parallel branch of the radio frequency signal channel disposed between the common signal input/output end and a first signal output end is turned off.

When the radio frequency signal is sent to the outside through the common signal input/output end, a switch device of the parallel branch disposed between the common signal input/output end and the first selection signal input end is turned off. In this way, a voltage between the common signal input/output end and the first selection signal input end is applied to the parallel branch, so that a part of the voltage is allocated to each switch device. When the radio frequency signal sent from the outside is received through the common signal input/output end, a switch device of the parallel branch disposed between the common signal input/output end and the first selection signal output end is turned off. In this way, a voltage between the common signal input/output end and the first selection signal output end is applied to the parallel branch, so that a part of the voltage is allocated to each switch device.

According to a second aspect, this application provides a radio frequency switch apparatus. The radio frequency switch apparatus includes: the radio frequency switch circuit in the first aspect, a radio frequency signal generation circuit, and a radio frequency signal receiving circuit. The radio frequency signal generation circuit is configured to provide a radio frequency signal for a radio frequency signal channel of the radio frequency switch circuit, and the radio frequency signal receiving circuit receives the radio frequency signal sent by the radio frequency signal channel of the radio frequency switch circuit.

According to a third aspect, this application provides an antenna apparatus, including a baseband module, an antenna link module, and the radio frequency switch apparatus according to the second aspect.

According to a fourth aspect, this application provides a terminal, including the antenna apparatus according to the third aspect.

### BRIEF DESCRIPTION OF DRAWINGS

FIG. 1 is a diagram 1 of a structure of a radio frequency switch circuit;
FIG. 2 is a diagram 2 of a structure of a radio frequency switch circuit;
FIG. 3 is a diagram 3 of a structure of a radio frequency switch circuit;
FIG. 4 is a diagram 4 of a structure of a radio frequency switch circuit; and
FIG. 5 is a diagram 5 of a structure of a radio frequency switch circuit.

### DESCRIPTION OF EMBODIMENTS

To make the objectives, technical solutions, and advantages of this application clearer, the following further describes this application in detail with reference to the accompanying drawings. However, example embodiments may be implemented in a plurality of forms and should not be construed as being limited to embodiments described herein. On the contrary, these embodiments are provided such that this application is more comprehensive and complete and fully conveys the concept of the example embodiments to persons skilled in the art. Identical reference numerals in the accompanying drawings denote identical or similar structures. Therefore, repeated description thereof is omitted. Expressions of locations and directions in this application are described by using the accompanying drawings as an example. However, changes may also be made as required, and all the changes fall within the protection scope of this application. The accompanying drawings in this application are merely used to illustrate relative position relationships and do not represent an actual scale.

To make the objectives, technical solutions, and advantages of this application clearer, the following further describes this application in detail with reference to the accompanying drawings. A specific operation method in a method embodiment may also be applied to an apparatus embodiment or a system embodiment. It should be noted that in description of this application, "at least one" means one or more, and "a plurality of' means two or more. In view of this, in embodiments of the present invention, "a plurality of' may also be understood as "at least two". The term "and/or" describes an association relationship for describing associated objects and indicates that three relationships may exist. For example, A and/or B may indicate the following three cases: Only A exists, both A and B exist, and only B exists. In addition, the character "/" generally indicates an "or" relationship between the associated objects. In addition, it should be understood that in description of this application, terms such as "first" and "second" are merely used for distinguishing and description, but should not be understood as indicating or implying relative importance, or should not be understood as indicating or implying a sequence.

It should be noted that, in embodiments of this application, "connection" means an electrical connection, and a connection between two electrical elements may be a direct or indirect connection between the two electrical elements. For example, a connection between A and B may be a direct connection between A and B, or may be an indirect connection between A and B through one or more other electrical elements. For example, that A is connected to B may alternatively be that A is directly connected to C, C is directly connected to B, A and B are connected through C.

The following describes some terms in embodiments of this application, to facilitate understanding of persons skilled in the art.
(1) Power tolerance: indicates a maximum input power of signals that can be accessed by passive devices or circuits that contain passive devices. If an input power exceeds the maximum input power, the passive device may be damaged.
(2) A breakdown voltage is a voltage that causes a dielectric to break down. Under the action of a strong electric field, the dielectric loses its dielectric properties and becomes a conductor, which is referred to as dielectric breakdown. A corresponding voltage is referred to as the breakdown voltage.

In view of this, this application provides a radio frequency switch circuit, so that even voltages are allocated to the switch devices, thereby achieving a maximum power tolerance.

The technical solutions in embodiments of this application may be applied to various communication systems, for example, a long term evolution (long term evolution, LTE) system, an LTE frequency division duplex (frequency division duplex, FDD) system, an LTE time division duplex (time division duplex, TDD) system, a 5th generation (5th generation, 5G) system, new radio (new radio, NR), or the like. This is not limited herein.

The communication system may be a terminal or a base station in embodiments of this application. The communication system may include a plurality of components, for example, an application subsystem, a memory (memory), a massive storage (massive storage), a baseband subsystem, a radio frequency integrated circuit (radio frequency integrated circuit, RFIC), a radio frequency circuit (radio frequency front-end, RFFE) device, and an antenna (antenna, ANT). These components may be coupled through various buses or in other electrical connection manners.

As mobile communication technologies develop, a plurality of communication standards coexist. Therefore, radio frequency power amplifiers in a plurality of modes and frequency bands are integrated into an architecture of a radio frequency front-end, and a required power amplifier needs to be selected by using a radio frequency switch circuit, to establish signal receiving and transmitting channels, so as to implement switching between different communication networks. Currently, architectures of most existing radio frequency front-ends include a plurality of radio frequency switch circuits, and each radio frequency switch circuit includes a plurality of switch devices. When a high-power signal is input, due to a parasitic capacitance effect of each switch device, voltages allocated to the switch devices are uneven, and a higher voltage is allocated to a switch device that is closer to a radio frequency signal.

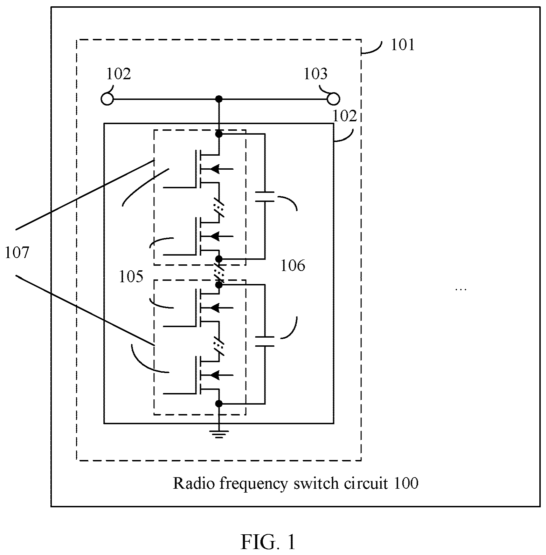

FIG. 1 is a diagram 1 of a structure of a radio frequency switch circuit. A radio frequency switch circuit 100 includes at least one radio frequency signal channel 101, each radio frequency signal channel 101 includes a signal input end 102 configured to input a radio frequency signal, a signal output end 103 configured to output a radio frequency signal, and a parallel branch 104 disposed between the signal input end and the ground or between the signal output end and the ground.

The parallel branch 104 includes a plurality of switch devices 105 and a plurality of first capacitors 106, first electrodes and second electrodes of the plurality of switch devices 105 are sequentially connected, a first electrode of a 1^{st} switch device 105 is connected to the signal input end or the signal output end, and a second electrode of a last switch device 105 is grounded. The plurality of switch devices 105 are divided into a plurality of switch device groups 107, and each switch device group 107 includes at least one switch device 105. In each switch device group 107, a first electrode of a switch device 105 that is close to the signal input end 102 or the signal output end 103 is connected, through the first capacitor 106, to a second electrode of a switch device 105 that is at the signal input end 102 or the signal output end 103.

To achieve higher isolation performance, the parallel branch 104 may be disposed between the signal input end and the ground or between the signal output end and the ground. Because a radio frequency voltage swing of the radio frequency signal is large, the parallel branch 104 need to stack a sufficient quantity of switch devices 105, so that an allocated voltage of each switch device 105 does not exceed a breakdown voltage. In addition, after the circuit is packaged into a chip, a parasitic capacitor exists between the ground of a packaging substrate and the first electrode and the second electrode of each switch device 105.

It should be noted that the switch device 105 provided in this application may be one or more of a plurality of types of switching devices such as an N-type or a P-type metal-oxide semiconductor field-effect transistor (metal-oxide semiconductor field-effect transistor, MOSFET), a bipolar junction transistor (bipolar junction transistor, BJT), an insulated gate bipolar transistor (insulated gate bipolar transistor, IGBT), or a silicon carbide (SiC) power transistor. The switch devices are not listed one by one in embodiments of this application.

Each switch device 105 may include a first electrode, a second electrode, and a control electrode, where the control electrode is configured to control turning on or off of the switch device 105. When the switch device 105 is turned on, a current can be transmitted between the first electrode and the second electrode of the switch device 105. When the switch device 105 is turned off, a current cannot be transmitted between the first electrode and the second electrode of the switch device 105. A MOSFET is used as an example. The control electrode of the switch device 105 is a gate, the first electrode of the switch device 105 may be a source of the switch device 105, and the second electrode may be a drain of the switch device 105. Alternatively, the first electrode may be a drain of the switch device 105, and the second electrode may be a source of the switching device 105. In the following embodiment, a switch device MOSFET is used as an example.

To avoid damage to the radio frequency switch circuit 100 caused by uneven voltage allocation of each switch device 105, in an implementation, each switch device group 107 includes one switch device 105, and the source of the switch device 105 is connected to the drain of the switch device 105 through the first capacitor 106, so that a voltage allocated to each switch device 105 is less than a breakdown voltage of the switch device 105, thus preventing damage to the radio frequency switch circuit 100.

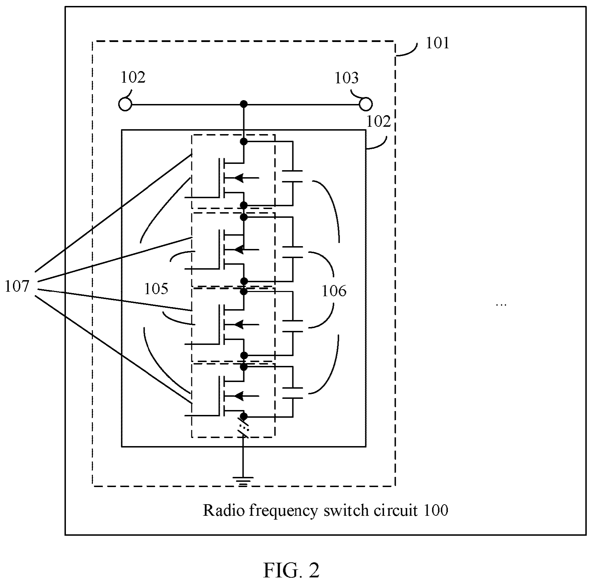

FIG. 2 is a diagram 2 of a structure of a radio frequency switch circuit. When each switch device group 107 includes one switch device 105, the first capacitor 106 is configured to adjust a parasitic capacitor on each switch device 105, so that a voltage allocated to each switch device 105 is less than a breakdown voltage of the switch device 105.

The parasitic capacitor is formed by an internal structure of the switch device 105, and may be considered as a virtual capacitor of each switch device 105. A field-effect transistor is used as an example. Two metal layers are disposed on a silicon substrate inside the field-effect transistor, and there is a capacitance value between the two metal layers. In this case, it may be considered that the field-effect transistor has a parasitic capacitance.

For example, a 1^{st} switch device 105 to an N^{th} switch device 105 are arranged between a ground cable and the signal input end or the signal output end, a source of the first switch device 105 is connected to the signal input end or the signal output end, and a drain of the N^{th} switch device 105 is grounded. First electrodes and second electrodes of N switch devices 105 are sequentially connected, to form a series structure of N+1 nodes. The switch devices 105 are sequentially arranged by using sequence numbers. Sequence numbers of the switch devices 105 are from 1 to N. For example, from the signal input end or the signal output end to the ground cable, the switch devices 105 are arranged in a sequence of the 1^{st} switch device, a 2^{nd} switch device, ..., and the N^{th} switch device. Alternatively, the 1^{st} switch device, the 2^{nd} switch device, and the N^{th} switch device may be arranged from the ground cable to the signal input end or the signal output end. In the foregoing two connection manners, a same point lies in that the switch devices 105 are connected in series, a source of the switch device 105 is connected to a drain of the switch device 105 adjacent to the switch device 105, and a drain of the switch device 105 is connected to a source of another switch device 105 adjacent to the switch device 105. A difference lies in a sequence number arrangement manner of the switch device 105.

Because a voltage between the ground cable and the signal input end 102 or the signal output end 103 is distributed to each switch device 105 in an entire loop, a part of the voltage is allocated to each switch device 105. If parasitic capacitances generated by the switch devices 105 are approximately the same, the switch device 105 that is closer to the signal input end or the signal output end bears a higher voltage.

A reason why the switch device 105 that is closer to the signal input end or the signal output end bears a higher voltage is that a current input from the switch device 105 that is closer to the signal input end or the signal output end is gradually shunted by parasitic capacitors arranged in sequence. For a leakage radio frequency current formed based on the parasitic capacitor, the switch device 105 that is closer to a radio frequency signal has a larger impedance and a higher voltage. The N switch devices and the N+1 nodes form N parasitic capacitors, an (N+1) ^{th} node is connected to an N^{th} parasitic capacitor, and the first capacitor 106 connected to two ends of each switch device is configured to adjust a parasitic capacitor generated on each switch device.

If a capacitance value of the parasitic capacitor can be reduced, a formed leakage radio frequency current can be reduced. If the impedance of the switch device 105 close to the radio frequency signal needs to be reduced, correspondingly, the first capacitor 106 with a larger capacitance value needs to be connected in parallel to the switch device 105 close to the radio frequency signal. The first capacitor 106 is connected in parallel to an inherent parasitic capacitor in the switch device 105, so that a voltage allocated to each switch device 105 in the radio frequency switch circuit 100 is less than a breakdown voltage of the switch device 105. This improves uniformity of a voltage drop on each switch device 105, further improves a voltage withstand capability of the radio frequency switch circuit 100, and avoids a problem that the switch device 105 in the radio frequency switch circuit 100 is prone to damage when subject to inconsistent voltages.

In addition, even if each switch device 105 generates a different parasitic capacitance, the first capacitors 106 with different capacitance values are connected in parallel based on the inherent parasitic capacitance of the switch device 105, so that a voltage allocated to each switch device 105 in the radio frequency switch circuit 100 may be less than a breakdown voltage of the switch device 105.

However, it is understood that a larger capacitance value of the capacitor indicates a larger area of the capacitor. Therefore, for some switch devices 105 in front, when the capacitance value of the first capacitor 106 is large, a larger circuit layout area is occupied, and parasitic effect is further deteriorated.

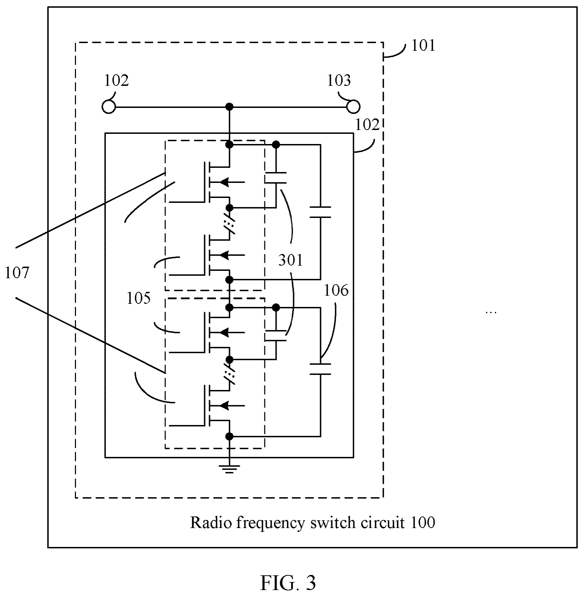

FIG. 3 is a diagram 3 of structure of a radio frequency switch circuit. In an implementation, each switch device group 107 may include at least two switch devices 105, and the parallel branch 104 further includes a plurality of second capacitors 301. A first electrode and a second electrode of a switch device 105 that is close to the signal input end 102 or the signal output end 103 in each switch device group 107 are connected through the second capacitor 301.

To avoid a problem that the first capacitor 106 occupies an excessively large area, for a switch device 105 that needs to be connected in parallel to a capacitor with a large capacitance value to implement voltage equalization, on the basis that in each switch device group 107, the first electrode of the switch device 105 that is close to the signal input end 102 or the signal output end 103 is connected, through the first capacitor 106, to a second electrode of a switch device 105 that is at the signal input end 102 or the signal output end 103, because a switch device 105 close to a radio frequency signal needs to be connected in parallel to a capacitor with a larger capacitance, the first electrode and the second electrode of the switch device 105 that is close to the signal input end 102 or the signal output end 103 in each switch device group 107 may be connected through the second capacitor 301. By using the foregoing structure, it is equivalent to that the switch device 105 close to the radio frequency signal in each switch device group 107 is connected in parallel to both the first capacitor 106 and the second capacitor 301, and that another switch device 105 in each switch device group 107 is connected in parallel to the first capacitor 106. In this way, even if a capacitor with a large capacitance value needs to be connected in parallel, in the structure provided in this application, a capacitance value of each capacitor may be reduced by superimposing the first capacitor 106 and the second capacitor 301, to reduce a circuit layout area.

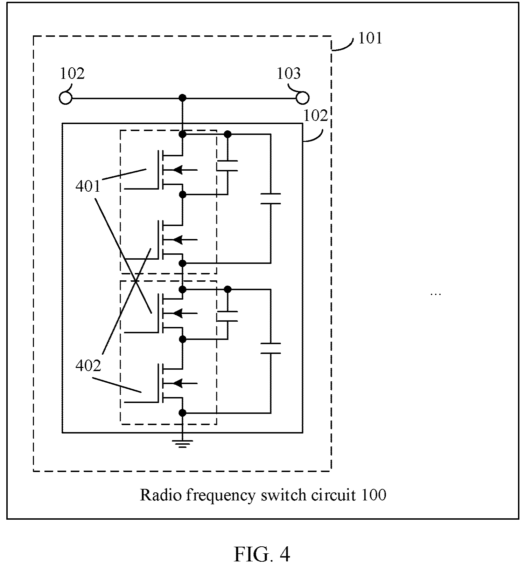

FIG. 4 is a diagram 4 of a structure of a radio frequency switch circuit. In an implementation, each switch device group 107 includes a first switch device 401 and a second switch device 402, the first switch device 401 is close to the signal input end 102 or the signal output end 103, the second switch device 402 is far away from the signal input end 102 or the signal output end 103, a first electrode of the first switch device 401 is connected to a second electrode of the second switch device 402 through the first capacitor 106, and the first electrode and a second electrode of the first switch device 401 are connected through the second capacitor 301.

In this structure, starting from the switch device close to the signal input end or the signal output end, every two switch devices are considered as a whole, and one first capacitor 106 is first connected in parallel to the two switch devices, to implement voltage equalization between the switch device groups 107. When parasitic capacitances from switch devices to the ground are the same, a largest capacitance value of the first capacitor 106 may be reduced by one time, thereby greatly reducing a layout area. Then, the second capacitor 301 is connected in parallel to the first switch device 401 close to the signal input end or the signal output end in the switch device group 107, to equalize voltages of the first switch device 401 and the second switch device 402 in the switch device group 107. Finally, allocated voltages of all the switch devices are basically equal, and a maximum power tolerance of the radio frequency switch circuit 100 is increased.

In addition, capacitance values of the first capacitor 106 and the second capacitor 301 may be allocated based on layout areas occupied by the first switch device 401 and the second switch device 402. In other words, because the switch devices connected in series in the parallel branch 104 are in a stacked state, to prevent parasitic effect from further deteriorating, layout areas occupied by the first capacitor 106 and the second capacitor 301 cannot be greater than the layout areas occupied by the first switch device 401 and the second switch device 402.

In an implementation, because the switch device far away from the signal input end 102 or the signal output end 103 has a small allocated voltage, the switch device far away from the signal input end 102 or the signal output end 103 may not be connected in parallel to the first capacitor 106. This reduces costs.

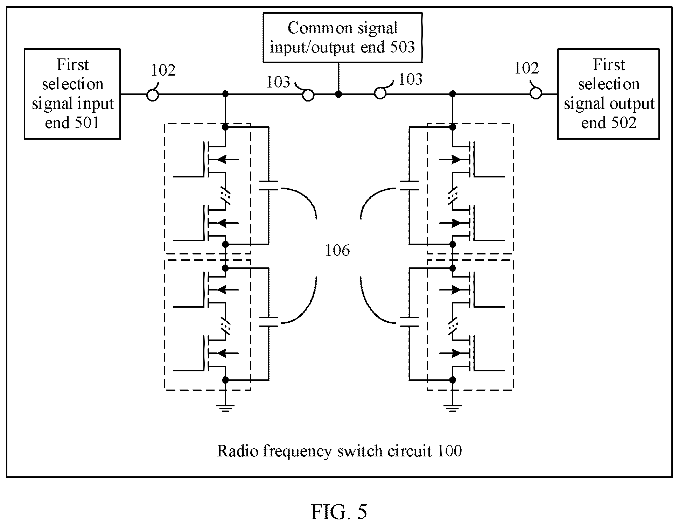

FIG. 5 is a diagram 5 of a structure of a radio frequency switch circuit. In an implementation, the radio frequency switch circuit 100 further includes: a first selection signal input end 501, a first selection signal output end 502, and a common signal input/output end 503, where the first selection signal input end 501 is configured to send a radio frequency signal to the common signal input/output end 503; and the common signal input/output end 503 is configured to send, to the outside, the radio frequency signal input from the first signal input end, and is further configured to receive an external radio frequency signal and transmit the received external radio frequency signal to the first selection signal output end 502.

The radio frequency switch circuit 100 specifically includes two radio frequency signal channels 101. One radio frequency signal channel 101 is disposed between the common signal input/output end 503 and the first selection signal input end 501, and the other radio frequency signal channel 101 is disposed between the common signal input/output end 503 and the first selection signal output end 502.

The shown radio frequency switch circuit 100 is a single-pole double-throw (single-pole double-throw, SPDT) radio frequency transceiver switch circuit. When the radio frequency switch circuit 100 is configured to transmit a radio frequency signal to the outside, the radio frequency switch circuit 100 is in a transmit mode. The radio frequency signal is generated by a transmitter, processed by an amplification circuit, flows in from the first selection signal input end 501, and is transmitted by the common signal input/output end 503. When the radio frequency switch circuit 100 is configured to receive a radio frequency signal from the outside, the radio frequency switch circuit 100 is in a receive mode. After being received from the common signal input/output end 503, the radio frequency signal flows into the first selection signal output end 502, to be transmitted to a receiver. The single-pole double-throw radio frequency transceiver switch circuit may further include a plurality of radio frequency signal channels 101. In this case, there may be a plurality of selection signal input ends and a plurality of selection signal output ends, and the parallel branch 104 is disposed between each selection signal input end and the common signal input/output end 503, and between each selection signal output end and the common signal input/output end 503, so that a plurality of radio frequency signals can be transmitted and received.

In an implementation, when the radio frequency switch circuit 100 sends the radio frequency signal to the outside through the common signal input/output end 503, a switch device of the parallel branch 104 of the radio frequency signal channel 101 disposed between the common signal input/output end 503 and the first selection signal input end 501 is turned off. When the radio frequency switch circuit 100 receives an external radio frequency signal form the common signal input/output end 503, a switch device of the parallel branch 104 of the radio frequency signal channel 101 disposed between the common signal input/output end 503 and a first signal output end is turned off.

In this way, when the radio frequency signal is sent to the outside through the common signal input/output end 503, the switch device of the parallel branch 104 disposed between the common signal input/output end 503 and the first selection signal input end 501 is turned off. Therefore, a voltage between the common signal input/output end 503 and the first selection signal input end 501 is applied to the parallel branch 104, so that a part of the voltage is allocated to each switch device.

When the radio frequency signal sent from the outside is received through the common signal input/output end 503, a switch device of the parallel branch 104 disposed between the common signal input/output end 503 and the first selection signal output end 502 is turned off. In this way, a voltage between the common signal input/output end 503 and the first selection signal output end 502 is applied to the parallel branch 104, so that a part of the voltage is allocated to each switch device.

According to the radio frequency switch circuit provided in this application, when each switch device of the parallel branch is turned off, a voltage between a signal input end that inputs a radio frequency signal and a signal output end that outputs a radio frequency signal is applied to the entire parallel branch, and a part of the voltage is allocated between the first electrode and the second electrode of each switch device. The first capacitor and the second capacitor are disposed, so that a voltage allocated to each switch device on the parallel branch is less than a breakdown voltage of the switch device. In addition, because both voltage equalization between switch device groups and voltage equalization within a switch device group are used, it can be ensured that voltages allocated to each switch device are basically equal, and a layout area is reduced.

Based on a same concept, this application further provides a radio frequency switch apparatus. The radio frequency switch apparatus includes the radio frequency switch circuit described in the foregoing embodiments, a radio frequency signal generation circuit, and a radio frequency signal receiving circuit. The radio frequency signal generation circuit is configured to provide a radio frequency signal for a radio frequency signal channel of the radio frequency switch circuit, and the radio frequency signal receiving circuit receives a radio frequency signal sent by the radio frequency signal channel of the radio frequency switch circuit.

The radio frequency signal generation circuit may include devices such as a digital-to-analog converter (digital-to-analog converter, DAC) and a frequency mixer. Before a radio frequency signal of each radio frequency signal generation circuit is transmitted through an antenna, power adjustment processing is further performed on an output signal of the radio frequency signal generation circuit via a power amplifier (power amplifier, PA).

The radio frequency signal receiving circuit may include devices such as a frequency mixer, a filter, and an analog-to-digital converter (analog-to-digital converter, ADC). A radio frequency signal received by the radio frequency signal receiving circuit from an antenna may be further processed by devices such as a low noise amplifier (low noise amplifier, LNA).

Based on a same concept, this application further provides an antenna apparatus, including a baseband module, an antenna link module, and the radio frequency switch apparatus described in the foregoing embodiments.

The baseband module may be integrated into one or more chips, and the chip may be referred to as a baseband processing chip or a baseband chip. The baseband module may be used as an independent chip, and the chip may be referred to as a modem (modem) or a modem chip. The baseband module may be manufactured and sold by using a modem chip as a unit. The modem chip is sometimes also referred to as a baseband processor or a mobile processor. In addition, the baseband module may be further integrated into a larger chip, and is manufactured and sold in a unit of a larger chip. The larger chip may be referred to as a system chip, a chip system, or a system on chip (system on a chip, SoC), or a SoC chip for short. Software components of the baseband module may be built in hardware components of a chip before the chip is delivered, or may be imported from another non-volatile memory to hardware components of a chip after the chip is delivered, or may be downloaded and updated online by using a network.

Based on a same concept, this application further provides a terminal. The terminal includes the foregoing antenna apparatus.

The foregoing embodiments are merely intended for describing the technical solutions of this application, but not for limiting this application. Although this application is described in detail with reference to the foregoing embodiments, persons of ordinary skill in the art should understand that modifications may still be made to the technical solutions described in the foregoing embodiments or equivalent replacements may be made to some technical features thereof, without departing from the spirit and scope of the technical solutions of embodiments of this application, and these modifications and replacements shall fall within the protection scope of this application.

## Claims

1. A radio frequency switch circuit, comprising at least one radio frequency signal channel, wherein each radio frequency signal channel comprises a signal input end configured to input a radio frequency signal, a signal output end configured to output a radio frequency signal, and a parallel branch disposed between the signal input end and the ground or between the signal output end and the ground, wherein
the parallel branch comprises a plurality of switch devices and a plurality of first capacitors, first electrodes and second electrodes of the plurality of switch devices are sequentially connected, a first electrode of a 1^{st} switch device is connected to the signal input end or the signal output end, and a second electrode of a last switch device is grounded; and
the plurality of switch devices are divided into a plurality of switch device groups, each switch device group comprises at least one switch device, and in each switch device group, a first electrode of a switch device that is close to the signal input end or the signal output end is connected, through the first capacitor, to a second electrode of a switch device that is at the signal input end or the signal output end.

2. The radio frequency switch circuit according to claim 1, wherein each switch device group comprises at least two switch devices, the parallel branch further comprises a plurality of second capacitors, and a first electrode and a second electrode of a switch device that is close to the signal input end or the signal output end in each switch device group are connected through the second capacitor.

3. The radio frequency switch circuit according to claim 2, wherein each switch device group comprises a first switch device and a second switch device, the first switch device is close to the signal input end or the signal output end, the second switch device is far away from the signal input end or the signal output end, a first electrode of the first switch device is connected to a second electrode of the second switch device through the first capacitor, and the first electrode and a second electrode of the first switch device are connected to each other through the second capacitor.

4. The radio frequency switch circuit according to any one of claims 1 to 3, wherein the switch device is an N-type MOS transistor or a P-type MOS transistor.

5. The radio frequency switch circuit according to any one of claims 1 to 4, wherein the radio frequency signal channel is configured to receive an external radio frequency signal or transmit a radio frequency signal to the outside.

6. The radio frequency switch circuit according to any one of claims 1 to 5, wherein the radio frequency switch circuit further comprises a first selection signal input end, a first selection signal output end, and a common signal input/output end, the first selection signal input end is configured to send a radio frequency signal to the common signal input/output end, and the common signal input/output end is configured to send, to the outside, a radio frequency signal input from the first signal input end, and is further configured to: receive an external radio frequency signal and transmit the received external radio frequency signal to the first selection signal output end; and
the radio frequency switch circuit specifically comprises two radio frequency signal channels, wherein one radio frequency signal channel is disposed between the common signal input/output end and the first selection signal input end, and the other radio frequency signal channel is disposed between the common signal input/output end and the first selection signal output end.

7. The radio frequency switch circuit according to claim 6, wherein when the radio frequency switch circuit sends a radio frequency signal to the outside through the common signal input/output end, a switch device of a parallel branch of the radio frequency signal channel disposed between the common signal input/output end and the first selection signal input end is turned off; and when the radio frequency switch circuit receives an external radio frequency signal through the common signal input/output end, a switch device of a parallel branch of the radio frequency signal channel disposed between the common signal input/output end and a first signal output end is turned off.

8. A radio frequency switch apparatus, wherein the radio frequency switch apparatus comprises the radio frequency switch circuit according to any one of claims 1 to 7, a radio frequency signal generation circuit, and a radio frequency signal receiving circuit, the radio frequency signal generation circuit is configured to provide a radio frequency signal for a radio frequency signal channel of the radio frequency switch circuit, and the radio frequency signal receiving circuit receives a radio frequency signal sent by a radio frequency signal channel of the radio frequency switch circuit.

9. An antenna apparatus, comprising a baseband module, an antenna link module, and the radio frequency switch apparatus according to claim 8.

10. A terminal, comprising the antenna apparatus according to claim 9.
